## Europäisches Patentamt
## European Patent Office
## Office européen des brevets

(11) Veröffentlichungsnummer: **0 003 038**
**B1**

(12) **EUROPÄISCHE PATENTSCHRIFT**

(45) Veröffentlichungstag der Patentschrift:
25.02.81

(51) Int. Cl.³: **H 01 J 37/30**, H 01 L 21/66

(21) Anmeldenummer: **78101821.3**

(22) Anmeldetag: **22.12.78**

(54) **Verfahren zum Messen von Ausrichtfehlern unter Verwendung eines Elektronenstrahlsystems als Messinstrument.**

(30) Priorität. 16.01.78 US 869972

(43) Veröffentlichungstag der Anmeldung:
25.07.79 Patentblatt 79/15

(45) Bekanntmachung des Hinweises auf die Patenterteilung:
25.02.81 Patentblatt 81/8

(84) Benannte Vertragsstaaten:
DE FR GB

(56) Entgegenhaltungen:
DE-A-2 424 313
FR-A-1 533 755
ELECTRONICS LETTERS, Vol. 12,
Nr. 1, 1976, Hitchin, Herts,
Seiten 28, 29.

(73) Patentinhaber: **International Business Machines Corporation, Armonk, N.Y. 10504 (US)**

(72) Erfinder: **Davis, Donald Eugene, 129 Edge Hill Drive, Wappingers Falls NY 12590 (US)**
Erfinder: **Weber, Edward Victor, 60 Round Hill Road, Poughkeepsie NY 12603 (US)**
Erfinder: **Williams, Maurice Carmen, 51 Brand Lane, Wappingers Falls NY 12590 (US)**
Erfinder: **Woodard, Ollie Clifton, 3 Ludlow Drive, Poughkeepsie NY 12601 (US)**

(74) Vertreter: **Böhmer, Hans Erich, Dipl.-Ing., Schönaicher Strasse 220, D-7030 Böblingen (DE)**

# Verfahren zum Messen von Ausrichtfehlern unter Verwendung eines Elektronen-strahlsystems als Meßinstrument

Die Erfindung betrifft ein Verfahren zum Messen eines Ausrichtfehlers zwischen zwei in einer mit Ausrichtmarkierungen versehenen Halbleiterscheibe an ausgewählten Stellen übereinander liegenden Mustern mit Hilfe eines Elektronenstrahls.

Bei der Fertigung von Halbleiterscheiben müssen für die Erzeugung bestimmter Halbleitervorrichtungen und der sie verbindenden Leitungen auf der Halbleiterscheibe mehrere übereinander liegende Schichten erzeugt werden. Das hat zur Folge, daß beispielsweise die Basis einer Halbleitervorrichtung in einer ersten Schicht ganz exakt mit einer Emitterzone für die gleiche Halbleitervorrichtung ausgerichtet werden muß, wobei die Emitterzone als Teil einer zweiten Schicht oder eines entsprechenden Verfahrensschritts gebildet wird. Die nicht sorgfältige Ausrichtung zwischen einem Merkmal in der ersten Schicht und einem Merkmal in einer später aufgebrachten Schicht wird allgemein als Ausrichtfehler bezeichnet.

Man hat im Stand der Technik schon verschiedene Verfahren für eine möglichst genaue Einstellung und Ausrichtung mehrerer Schichten miteinander eingesetzt.

So ist es beispielsweise an sich aus Electronic Letters, Band 12, Nr. 1, 1976, Seite 28, bekannt, zur Ausrichtung des Elektronenstrahls bei der Abtastung von Feldern auf einer Halbleiterscheibe anstelle von bisher verwendeten Ausrichtmarken die Kante eines bereits belichteten Musters als Ausrichtmarke zu verwenden. Dabei wird für die Ausrichtung des Strahls auf das nächste Feld die Kante des im vorhergehenden Feld belichteten Musters benutzt. Für den Suchvorgang bei der Strahlausrichtung wird dann die Strahlintensität beispielsweise durch Herabsetzen der Beschleunigungsspannung verringert. Ähnliches gilt für das aus der FR-PS 1 533 755 bzw. der entsprechenden DE-OS 1 690 626 bekannte Verfahren.

Gleichfalls ist auf die DE-OS 2 424 313 der Anmelderin zu verweisen, die sich ebenfalls mit der Ausrichtung des Substrats bzw. der Halbleiterscheibe mittels Ausrichtmarken befaßt. Ein und dasselbe Signal, das an den Ausrichtmarken abgeleitet wird, wird zur genauen Ermittlung der Eckpunkte der Halbleiterplättchen auf der Halbleiterscheibe mehrfach abgetastet.

Keines der bisher angewandten Verfahren hat dabei ein Elektronenstrahlsystem benutzt, das auch gleichzeitig bei dem Herstellverfahren unmittelbar als Schreibinstrument benutzt worden war. Der Einsatz eines Elektronenstrahlsystems als Meßinstrument für den Ausrichtfehler zwischen zwei verschiedenen Ebenen oder Schichten wird demgemäß als neu angesehen. Mit diesem Verfahren lassen sich große Datenmengen über Ausrichtfehler automatisch und genau ermitteln und sammeln, wobei durch Betriebspersonal verursachte Fehler, die sich aus einer bisher üblichen Art der Datenermittlung ergeben könnten, beseitigt werden. Dieses Verfahren beeinflußt auch den Kostenwirkungsgrad, da die Benutzung weiterer Instrumente für die Regelung oder Steuerung der Ausrichtung nicht erforderlich ist, weil in der bevorzugten Ausführungsform die Fertigungsvorrichtungen ohne Änderungen benutzt werden können.

Zum Stand der Technik sei insbesondere auf die US-Patentschrift 3 644 700 und vor allen Dingen auf die US-Patentschrift 4 056 730 verwiesen.

Die letztgenannte Patentschrift erscheint als Ausgangspunkt für die Erfindung von besonderer Wichtigkeit. In dieser Patentschrift ist eine Vorrichtung für die Feststellung von Ausrichtmarken auf einer Halbleiterscheibe offenbart, wobei über Diodendetektoren von der Prallplatte unter Rückstreuung ausgehende Elektronen aufgefangen werden. Die dort offenbarte Vorrichtung führt eine Differentiation des rückgestreuten Signals durch. Wenn mehr als ein Signal benutzt wird, dann wird eine Summenschaltung benutzt, die vor oder nach der Differentiation eine Summenbildung durchführt. Die in dieser Patentschrift offenbarte Vorrichtung dient der genauen Bestimmung des Zeitpunktes, wann der Elektronenstrahl des Systems über eine bestimmte Ausrichtmarke oder ein bestimmtes Kennzeichen hinwegläuft. Diese Patentschrift entspricht der deutschen Patentanmeldung P 27 31 142.8.

Die vorliegende Erfindung betrifft ein Verfahren zum Messen des Ausrichtfehlers in Halbleiterscheiben unter Verwendung eines Elektronenstrahlsystems, das ähnlich aufgebaut ist, wie die in den beiden oben genannten Patentschriften beschriebenen Systeme, und insbesondere ein Elektronenstrahlsystem, das einen Detektor verwendet, wie er beispielsweise in der bereits erwähnten deutschen Patentanmeldung P 27 31 142.8 beschrieben ist.

Ein Verfahren der eingangs genannten Art zeichnet sich dadurch aus, daß ein erstes Ausrichtmuster auf der Halbleiterscheibe an einem vorbestimmten Ort in bezug auf die Ausrichtmarkierungen angebracht wird, daß anschließend in einer über diesem ersten Ausrichtmuster liegenden Schicht ein zweites Ausrichtmuster an einem vorbestimmten Ort in bezug auf die Ausrichtmarkierungen angebracht wird, daß dann mittels Elektronenstrahlabtastung der relative seitliche Abstand zwischen dem zweiten Ausrichtmuster und dem ersten Ausrichtmuster in mindestens einer Abtastrichtung gemessen wird, und der dem gemessenen Abstand proportionale Ausrichtfehler zwischen den beiden Ausrichtmustern festgestellt wird, indem bei Abtastung durch den Elektronenstrahl in dem durch Rückstreuung der Elektronen erzeugten Signal die bei Überfahren der Kanten der Ausrichtmuster auftretenden Signalübergänge ermittelt werden und aus der Verarbeitung dieser Signalübergänge die Mittellinien der beiden Ausrichtmuster und ihr gegenseitiger Abstand ermittelt wird, woraus der Ausrichtfehler zwischen den beiden Ausrichtmustern errechnet werden kann.

Dabei geht man vorzugsweise so vor, daß das erste Ausrichtmuster mit Hilfe eines Elektronenstrahls in bezug auf die Ausrichtmarkierungen an dem vorbestimmten Ort auf der Halbleiterscheibe aufgezeichnet wird, daß dann der Elektronenstrahl an den auf der Halbleiterscheibe angebrachten Ausrichtmarkierungen ausgerichtet wird, daß dann an einem in der Nachbarschaft des ersten Ausrichtmusters liegenden Ort auf der Halbleiterscheibe das zweite Ausrichtmuster aufgezeichnet wird und daß dann mit Hilfe dieses Elektronenstrahlsystems die Relativ-Abweichung zwischen dem zweiten Muster und dem ersten Muster in mindestens einer axialen Richtung als Relativ-Fehler gemessen wird, der für die Berechnung des Ausrichtfehlers für weitere Muster auf der Halbleiterscheibe verwendet werden kann.

Die von den Kanten erzeugten Analogsignale werden in einer Schaltung verarbeitet, die ähnlich aufgebaut ist, wie die in der genannten Patentanmeldung P 27 31 142.8 gezeigte Schaltung, die die Kantenpositionen darstellende digitale Daten liefert. Diese Daten werden zur Bestimmung des Ausrichtfehlers gesammelt, verfeinert und mit noch im einzelnen zu beschreibenden Mitteln reduziert. Die so ermittelten Ausrichtfehler können in bekannter Weise zur Verhinderung oder Verminderung von Ausrichtfehlern eingesetzt werden, die bei der Bearbeitung nachfolgender Halbleiterscheiben auftreten könnten.

Die Erfindung wird nunmehr anhand eines Ausführungsbeispiels in Verbindung mit den beigefügten Zeichnungen im einzelnen näher erläutert.

In den Zeichnungen zeigt

Fig. 1 schematisch ein Elektronenstrahlsystem mit Einrichtungen zum Steuern des Strahls,

Fig. 2 schematisch ein Blockschaltbild für die Feststellung und Verarbeitung der in dem System gemäß Fig. 1 auftretenden und ermittelten Signale, die gemäß der Erfindung verarbeitet werden,

Fig. 3 eine Draufsicht auf eine Gruppe von Ausrichtmarken und Ausrichtmustern, wie sie bei der Durchführung der Erfindung verwendet werden,

Fig. 4A eine Darstellung des vertikalen Profils der in Fig. 3 gezeigten Ausrichtmuster und

Fig. 4B eine Darstellung der durch die Schaltung in Fig. 2 erzeugten elektrischen Signale, wenn der Elektronenstrahl solche Ausrichtmuster abtastet.

## Einzelbeschreibung der Erfindung

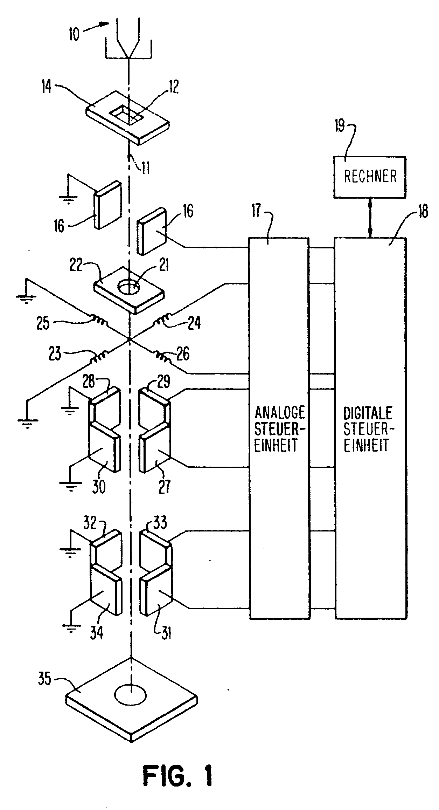

Fig. 1 zeigt ein Elektronenstrahl-Erzeugungssystem 10, das in bekannter Weise einen Ladungsträgerstrahl erzeugt. Dieser Ladungsträgerstrahl oder Elektronenstrahl 11 durchsetzt eine Lochblende 14 mit einer der Strahlformung dienenden Öffnung 12. Der Elektronenstrahl 11 hat vorzugsweise quadratischen Querschnitt, dessen Abmessungen der kleinsten Linienbreite des zu bildenden Musters entspricht.

Der Elektronenstrahl durchläuft ein Paar Austastplatten 16, die bestimmen, wann der Elektronenstrahl 11 auf das Material gerichtet wird und wann er ausgetastet wird. Die Austastplatten 16 werden durch Schaltungen in einer Analogsteuereinheit 17 gesteuert. Die Analogsteuereinheit wird durch eine digitale Steuereinheit 18 gesteuert, wie dies beispielsweise in der deutschen Patentanmeldung P 24 43 625.7 beschrieben ist. Die digitale Steuereinheit 18 ist an einem Rechner 19 angeschlossen, der vorzugsweise ein IBM-System /370 ist.

Der Elektronenstrahl durchläuft eine kreisförmige Öffnung 21 in einer Lochblende 22. Diese Lochblende bewirkt, daß nur die durch die Mitten der Linsen (nicht gezeigt) hindurchtretenden Ladungsträgerteilchen benutzt werden, so daß ein quadratischer Fleck ohne jegliche Verzerrung erzeugt wird.

Der Elektronenstrahl 11 durchläuft dann magnetische Ablenkspulen 23, 24, 25 und 26, wobei die magnetischen Ablenkspulen 23 und 24 die Ablenkung des Elektronenstrahls in einer waagerechten oder X-Richtung steuern, während die magnetischen Ablenkspulen 25 und 26 die Ablenkung des Elektronenstrahls 11 in einer dazu senkrechten oder Y-Richtung steuern. Die magnetischen Ablenkspulen 23 bis 26 steuern den Elektronenstrahl 11 also in seiner horizontalen Abtastbewegung. Obgleich der Elektronenstrahl im wesentlichen rasterartig bewegt werden könnte, so wird er doch vorzugsweise eine hin- und hergehende Abtastung ausführen, so daß der Elektronenstrahl sich längs benachbarter Linien jeweils in entgegengesetzter Richtung bewegt.

Der Elektronenstrahl durchläuft dann einen ersten Satz elektrostatischer Ablenkplatten 27, 28, 29 und 30. Die elektrostatischen Ablenkplatten 27 und 28 bewirken dabei eine Ablenkung des Strahls in einer waagerechten oder X-Richtung, während die elektrostatischen Ablenkplatten 29 und 30 den Elektronenstrahl 11 in einer dazu senkrechten oder Y-Richtung bewegen. Den Ablenkplatten 27 bis 30 wird dabei für die Ablenkung des Elektronenstrahls 11 eine zusätzliche Ablenkspannung zugeführt, die sich aus der Abweichung $\Delta E$ zwischen den Mittellinien der jeweiligen Ausrichtmuster ergibt. Die Ablenkplatten 31—34 sind dabei die eigentlichen normalen Ablenkplatten, während die Hilfsablenkung über die Ablenkplatten 27—30 erfolgt.

Der Elektronenstrahl trifft dann auf die auf einem Tisch 35 liegende, zu bearbeitende Halbleiterscheibe auf. Der Tisch 35 ist dabei ebenfalls in X- und Y-Richtung bewegbar.

Der Elektronenstrahl durchläuft dabei einen A-, B- und C-Zyklus, wie dies ausführlich in der US-Patentschrift 3 644 700 beschrieben ist, und die Signale werden dann während des A-Zyklus des Elektronenstrahls 11 verarbeitet, um den Ort einer jeden Ausrichtmarke festzustellen. In jeder der vier Ecken eines jeden der vielfachen Felder auf einer Halbleiterscheibe ist je eine Ausrichtmarke angeordnet. Wenn sich die Felder überlappen, dann wird die gleiche Ausrichtmarke für jedes der vier aneinander anstoßenden Felder benutzt. Dabei wird die Ausrichtmarke an jeder der vier Ecken des Feldes zur Festlegung des Feldes benutzt, in dem ein Muster beschrieben werden soll. Der genaue Ort einer jeden Ausrichtmarke wird dadurch ermittelt, daß der Elektronenstrahl über die durch die Ausrichtmarken auf der Halbleiterscheibe geführten Kanten hinweggeführt wird. Die Abtastung des Elektronenstrahls erfolgt dabei in einer Richtung senkrecht zu den durch die Ausrichtmarken auf der Halbleiterscheibe gebildeten Kanten. Ein Ausrichtdetektor wird zur Feststellung des Zeitpunktes benutzt, wann der Elektronenstrahl 11 über die Kanten einer jeden dieser Marken läuft.

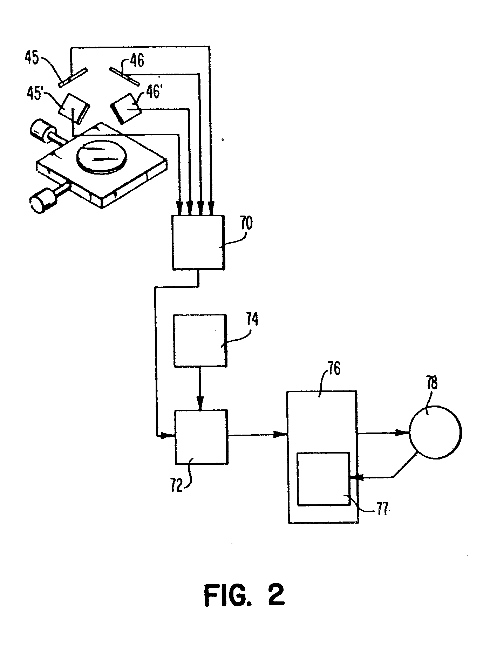

Der Ausrichtdetektor enthält vorzugsweise vier Dioden 45, 46, 45' und 46', die wie in Fig. 2 gezeigt, oberhalb der Halbleiterscheibe angeordnet sind und zwischen sich eine Öffnung bilden, durch die der Elektronenstrahl 11 hindurchtritt, bevor er auf einem Teil der Halbleiterscheibe auftrifft. Die vier Dioden 45, 46, 45' und 46' sind vorzugsweise in den vier Quadranten angeordnet.

Während einer X-Abtastung verändert sich die Rückstreuung der Elektronen von der Halbleiterscheibe dann, wenn der Elektronenstrahl über eine der Kanten einer der Streifen der X-Ausrichtmarke läuft. Jeder der Streifen der Ausrichtmarke wird dabei entweder durch einen vertieften oder einen erhöhten Abschnitt in der Oberfläche der Halbleiterscheibe gebildet.

Die vorliegende Erfindung verwendet die durch Rückstreuung erzeugten Signale, die auch für die Ausrichtung von Mustern benutzt werden, und benutzt diese Signale zum Messen anderer Merkmale auf der Oberfläche der Halbleiterscheibe als Anzeige für einen Ausrichtfehler. Dabei wird das Elektronenstrahlsystem zum Messen eines Ausrichtfehlers zwischen Ausrichtmustern in verschiedenen Ebenen innerhalb einer Halbleiterscheibe benutzt.

Die Messungen von Ausrichtfehlern werden an ausgewählten Stellen auf der Halbleiterscheibe durchgeführt, bei der ein aus einem Streifen bestehendes Ausrichtmuster in einer Schicht über einem aus zwei Streifen bestehenden Ausrichtmuster in einer anderen Materialschicht liegt, die während der Bearbeitung der Halbleiterscheibe aufgebracht werden. Die Position der Mittellinie des einen Ausrichtmusters in bezug auf die Mittellinie zwischen den zwei Streifen des anderen Ausrichtmusters liefert eine unmittelbare Anzeige für den Ausrichtfehler zwischen den beiden Ausrichtmustern.

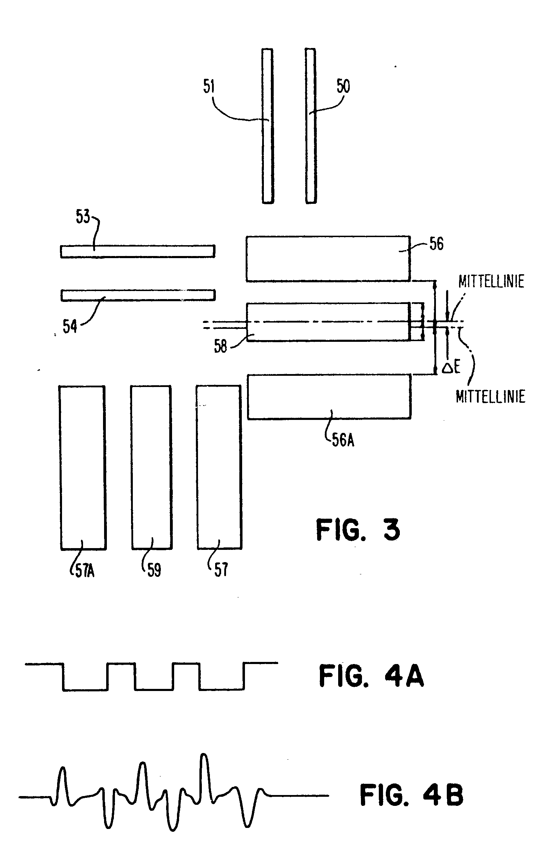

In Verbindung mit Fig. 2 bis 4 soll nunmehr dargelegt werden, wie die Ausrichtmuster aufgebracht werden. Gemäß Fig. 3 ist ein erstes Paar von Ausrichtmarken 50, 51 und ein zweites Paar von Ausrichtmarken 53, 54 dargestellt. Diese Ausrichtmarken sind an den vier Ecken eines jeden Feldes vorgesehen und stellen die für die Ausrichtung und Korrektur verwendeten Ausrichtmarken dar. Die Ausrichtmarken 50, 51 sind die Ausrichtmarken der X-Ablenkrichtung und die Ausrichtmarken 53, 54 die der Y-Ablenkrichtung. Für die Zwecke der vorliegenden Erfindung wird ein Paar von Ausrichtmarken anstelle eines einzigen Streifens verwendet.

Zusätzlich zu den Ausrichtmarken ist ein aus zwei Streifen bestehendes Ausrichtmuster 56, 56A und ein aus zwei Streifen bestehendes Ausrichtmuster 57 und 57A vorgesehen. Diese Ausrichtmuster sind an besonders bestimmten Stellen in bezug auf die zugehörigen Ausrichtmarken angebracht. Die Ausrichtmuster können in der gleichen Materialschicht oder während der gleichen Verfahrensschritte wie die Ausrichtmarken 50, 51, 53 und 54 angebracht werden. Andererseits können die Ausrichtmuster in einem gesonderten Verfahrensschritt angebracht werden, müssen jedoch dann durch das zuvor erläuterte Ausrichtverfahren mit den Ausrichtmarken ausgerichtet werden. Die Ausrichtung dieser Ausrichtmuster mit den Ausrichtmarken soll für ihre spätere Feststellung für die Abtastung durch den Elektronenstrahl bei der Messung des Ausrichtfehlers dienen.

In der bevorzugten Ausführungsform der Erfindung werden die ersten Ausrichtmuster 56, 56A, 57 und 57A in üblicher Weise durch Belichtung einer Photolackschicht durch Elektronenstrahl, durch Entwicklung der Photolackschicht und durch Ätzen in der Halbleiterscheibe gebildet. Dabei sollte jedoch klar sein, daß das erste aus zwei Streifen bestehende Ausrichtmuster auf der Halbleiterscheibe in einem anderen Verfahrensschritt angebracht wird als das zweite aus einem Streifen bestehende Ausrichtmuster 58, 59. Demnach ist der Ort des zweiten Ausrichtmusters 58, 59 in bezug auf das erste Ausrichtmuster 56, 56A, 57, 57A eine Anzeige für einen Ausrichtfehler, der sich aus der Ausrichtung der zweiten Schicht in bezug auf die erste Schicht ergibt.

Es sei darauf hingewiesen, daß das zweite Ausrichtmuster 58, 59 dadurch aufgebracht wird, daß zunächst der Elektronenstrahl mit den Ausrichtmarken ausgerichtet wird und daß dann die Ausrichtmuster in den gewünschten Positionen belichtet werden. Da jedoch die Ausrichtmarken der Ausrichtabtastung ausgesetzt sind und dadurch bei der nachfolgenden Bearbeitung verändert werden können, wird für die X- und Y-Ablenkrichtung ein zweiter Satz von Ausrichtmarken vorgesehen. Damit ist eine Ausrichtung an dem ersten Satz von Ausrichtmarken für die Bildung des zweiten Ausrichtmusters möglich, während der zweite Satz von Ausrichtmarken für die nachfolgende Feststellung des darüberliegenden Ausrichtmusters zum Abtasten und Messen verwendet werden kann.

Die Lage der Mittellinie des zweiten Ausrichtmusters in bezug auf die Mittellinien des ersten Ausrichtmusters ist für die X- und Y-Richtung in Fig. 3 gezeigt. Die senkrechte Schnittansicht des Ausrichtmusters zeigt Fig. 4A, und das beim Abtasten des Ausrichtmusters durch den Elektronenstrahl erzeugte elektrische Ausgangssignal ist in Fig. 4B gezeigt. Die Signaldarstellung von Fig. 4B ergibt sich somit aus der Differentiation eines Ausgangssignals und gestattet die genaue Ermittlung der Kanten der in Fig. 3 dargestellten Ausrichtmuster.

Zur Messung des Ausrichtfehlers auf einer gegebenen Halbleiterscheibe wird die automatische Ausrichtung und Korrekturmöglichkeit des Systems dazu benutzt, das Elektronenstrahl-Abtastmuster genau über den Ausrichtmarken in Position zu bringen. Nach Durchführung der beiden Messungen bewegt sich der X-Y-Tisch nach dem Ort des nächsten Halbleiterplättchens auf der Halbleiterscheibe. Die Orte der Halbleiterplättchen und die jeweiligen Positionen der Ausrichtmuster in bezug auf die Ausrichtmarken kann dabei, falls erwünscht, so angeordnet werden, daß Ausrichtfehler-Messungen an mehreren Punkten über einem Halbleiterplättchen möglich sind. Außerdem können die durch die Meßabtastungen ermittelten Daten auf einem Magnetband oder einem anderen Speichermedium für spätere Verfeinerung und Datenreduzierung aufgezeichnet werden.

Das beim Überfahren der Kante in der Halbleiterscheibe durch den Elektronenstrahl erzeugte Signal tritt so deutlich in Erscheinung, daß die Ausrichtung erkannt werden kann, selbst wenn die Ausrichtmuster unter einer mehrere Mikron starken Schicht eines darüberliegenden Materials liegen.

Die Verarbeitung der durch Elektronenrückstreuung erzeugten Signale soll nunmehr anhand von Fig. 2 erläutert werden. Wenn der Elektronenstrahl über das Ausrichtmuster auf der Oberfläche der Halbleiterscheibe hin- und hergeführt wird, dann wird das dabei festgestellte, durch Rückstreuung erzeugte Elektronensignal moduliert, wodurch ein Signal erzeugt wird, das von den oberhalb der Halbleiterscheibe angeordneten Elektronendetektoren aufgenommen wird. In der bevorzugten Ausführungsform sind vier Festkörperdioden als Detektoren vorgesehen.

Die von den Detektordioden kommenden Signale werden einer Analogsignalverarbeitungseinheit 70 zugeführt, die die Ausgangsströme der Dioden in Spannungsimpulse umwandelt. Diese Spannungsimpulse werden differenziert, zur Aussiebung unerwünschter Hochfrequenzanteile über ein Filter geleitet und dann aufsummiert. Die Amplitude des Summensignals wird durch eine automatische Verstärkungsregelung auf einen festen Wert eingeregelt.

Das Ausgangssignal wird dann einer Vergleichsschaltung zugeführt, die einen Teil der analogen Signalverarbeitungseinheit darstellt. An der Vergleichsschaltung liegt ein Bezugssignal, das automatisch auf einen festen Prozentsatz zwischen der Grundlinie und der Spitzenamplitude des Signals eingestellt ist. Die digitalen Ausgangssignale der Vergleichsschaltung werden dann einer der Zeitcodierung und der Datenzwischenspeicherung dienenden Schaltung 72 zugeführt, der außerdem von einem Taktgenerator 74 ein Taktsignal zugeleitet wird.

Die digitalen Signale werden dann in bezug auf das Systemtaktsignal, das mit der Strahlabtastablenkung synchron ist, zeitcodiert. Die zeitcodierten Signale werden dann einem Rechner zugeführt, der die Daten aus der Zeitcodierung und Datenzwischenspeicherung dienenden Schaltung 72 liest und auf einem Magnetband 78 abspeichert, bis sie in einem Prozessor 77 verarbeitet werden können.

Das Signal kann nach Umsetzung als Anzeige für den Abstand auf der Halbleiterscheibe zwischen der Mittellinie des ersten Ausrichtmusters und der Mittellinie des zweiten Ausrichtmusters benutzt werden. Für eine richtige Messung einer solchen Anzeige wird durch die Schaltung 77 das Signal auf die richtige Folge der Signalpolarität abgetastet, wobei dadurch gültige Daten für die Kanten und damit Tests für die richtige Breite der gemessenen Ausrichtmuster ausgewählt werden. Das ermöglicht die Ausblendung von verrauschten Datenpunkten, und die reduzierten Daten stellen ausschließlich Ausrichtdaten für das erste und das zweite Ausrichtmuster dar.

Somit stellen also die reduzierten Daten die Ausrichtfehler entweder in X- oder in Y-Richtung am Ort eines jeden abgetasteten Ausrichtmusterpaares dar. Die anschließende Weiterverarbeitung kann dann die gewünschten statistischen Werte und Korrelationen liefern, mit deren Hilfe vermutete Fehlerquellen übereinanderliegender Ausrichtmuster beseitigt werden können.

Eine solche weitere Verarbeitung wäre beispielsweise dann erforderlich, wenn der Ausrichtfehler durch irgendein anderes Verfahren gemessen worden wäre und ist somit nicht Teil der vorliegenden Erfindung.

Das vorliegende Verfahren zur Bestimmung des Ausrichtfehlers hat sich als wesentliche Verbesserung gegenüber anderen Methoden und Verfahren insoweit erwiesen, als es mit Hilfe eines Elektronenstrahlsystems durchgeführt wird, das bereits unmittelbar zum Aufzeichnen von Linien oder Leitungsmustern auf Halbleiterscheiben eingesetzt wird. Dadurch wird es nicht länger erforderlich, für die Messung ein anderes System einzusetzen als für das Beschreiben von Halbleiterscheiben. Außerdem besteht die Abtastung der Ausrichtmuster aus vorwärts und rückwärts verlaufenden Abtastungen, wodurch Fehler, die sich aus nicht-linearer Abtastung ergeben könnten, klein gehalten werden. Damit können außerdem Fehler kompensiert werden, die sich aus verschiedenen Verzögerungen innerhalb der Signalleitungen in dem System ergeben können, und es hat sich gezeigt, daß dies ein besonders genaues Verfahren ist. Außerdem wurden die für die Messungen in übereinander liegenden Schichten bestimmten Ausrichtmuster so gewählt, daß komplementäre Kantenpaare für die Feststellung eines Fehlers benutzt werden. Das wiederum beseitigt Auswirkungen von Kantenveränderungen oder Abweichungen bei den benutzten Ausrichtmustern.

Es sei ferner darauf hingewiesen, daß zwar in der ersten Ausführungsform ein Elektronenstrahl mit quadratischem Querschnitt benutzt wird, daß die Messungen auch mit einem Elektronenstrahl mit rundem oder vorzugsweise einem rechteckigen Strahlquerschnitt durchgeführt werden könnten, wenn dessen lange Kante parallel zu den zu messenden Kanten verläuft. Die erste Ausführungsform verwendet außerdem eine bestimmte Kombination von Signaldetektoren und analogen und digitalen Signalverarbeitungsschaltungen mit Störbefreiung, die jedoch durch andere geeignete Schaltungen ersetzbar sind. Beispielsweise könnten Szintillatoren die Diodendetektoren ersetzen, die automatische Verstärkungseinstellung könnte durch eine Handeinstellung ersetzt sein, und/oder die Kantenkennzeichnung könnte durch einen Spitzendetektor und nicht durch eine Abschneidschaltung ermittelt werden.

Es sei ferner darauf verwiesen, daß zwar die erste beschriebene Ausführungsform des Verfahrens in der Messung des Ausrichtfehlers zwischen einem ersten und einem zweiten Ausrichtmuster durchgeführt wird, das durch den direkt schreibenden Elektronenstrahl selbst erzeugt worden ist, doch ist dies Verfahren genauso in bezug auf die Messungen des Ausrichtfehlers zwischen Ausrichtmustern einsetzbar, die auf dem Halbleiterplättchen in anderer Weise erzeugt worden sind. Beispielsweise könnten die Ausrichtmuster auf der Halbleiterscheibe durch andere photolithographische Vorrichtungen üblicher Bauart erzeugt worden sein.

**Patentansprüche .**

1. Verfahren zum Messen eines Ausrichtfehlers zwischen zwei in einer mit Ausrichtmarkierungen versehenen Halbleiterscheibe an ausgewählten Stellen übereinander liegenden Mustern mit Hilfe eines Elektronenstrahls, dadurch gekennzeichnet, daß ein erstes Ausrichtmuster (56, 56A; 57, 57A) auf der Halbleiterscheibe an einem vorbestimmten Ort in bezug auf die Ausrichtmarkierungen angebracht wird, daß anschließend in einer über diesem ersten Ausrichtmuster liegenden Schicht ein zweites Ausrichtmuster (58, 59) an einem vorbestimmten Ort in bezug auf die Ausrichtmarkierungen angebracht wird, daß dann mittels Elektronenstrahlabtastung der relative seitliche Abstand zwischen dem zweiten Ausrichtmuster und dem ersten Ausrichtmuster in mindestens einer Abtastrichtung gemessen wird, und der dem gemessenen Abstand proportionale Ausrichtfehler zwischen den beiden Ausrichtmustern festgestellt wird, indem bei Abtastung durch den Elektronenstrahl in dem durch Rückstreuung der Elektronen erzeugten Signal die bei Überfahren der Kanten der Ausrichtmuster auftretenden Signalübergänge ermittelt werden und aus der Verarbeitung dieser Signalübergänge die Mittellinien der beiden Ausrichtmuster und ihr gegenseitiger Abstand ermittelt wird, woraus der Ausrichtfehler zwischen den beiden Ausrichtmustern errechnet werden kann.

2. Verfahren nach Anspruch 1, dadurch gekennzeichnet, daß das erste Ausrichtmuster mit Hilfe eines Elektronenstrahls in bezug auf die Ausrichtmarkierungen an dem vorbestimmten Ort auf der Halbleiterscheibe aufgezeichnet wird, daß dann der Elektronenstrahl an den auf der Halbleiterscheibe angebrachten Ausrichtmarkierungen ausgerichtet wird, daß dann an einem in der Nachbarschaft des ersten Ausrichtmusters liegenden Ort auf der Halbleiterscheibe das zweite Ausrichtmuster aufgezeichnet wird und daß dann mit Hilfe dieses Elektronenstrahlsystems die Relativ-Abweichung zwischen dem zweiten Ausrichtmuster und dem ersten Ausrichtmuster in mindestens einer axialen Richtung als Relativ-Fehler gemessen wird, der für die Berechnung des Ausrichtfehlers für weitere Muster auf der Halbleiterscheibe verwendet werden kann.

3. Verfahren nach Anspruch 2, dadurch gekennzeichnet, daß aus dem durch Elektronenrückstreuung erzeugten Signal Paare von Signalübergängen ermittelt werden, die beim Überfahren des Elektronenstrahls über Kanten eines vorgegebenen Musters auftreten.

**Claims**

1. Method of measuring by means of an electron beam an overlay error between two patterns overlaying each other in selected sites of a semiconductor wafer containing registration marks, characterized in that a first pattern (56, 56A; 57, 57A) is provided on the semiconductor wafer in a predetermined site with reference to the registration marks, that subsequently in a layer over this first pattern a second pattern (58, 59) is provided at a predetermined site with reference to the registration marks, that subsequently by means of electron beam scanning the relative lateral distance between the second pattern and the first pattern is measured in at least one scanning direction, and that the overlay error between the two patterns is determined which is proportional to the distance measured, by ascertaining during electron beam scanning, in the signal generated by electron back-scattering, the signal transitions appearing during the crossing of the pattern edges, and that the center lines of the two patterns and their mutual spacing is determined from the processing of these signal transitions so that the overlay error between the two patterns can be calculated.

2. Method as claimed in claim 1, characterized in that the first pattern is written by means of an electron beam with respect to the registration marks at the predetermined site on the semiconductor wafer, that subsequently the electron beam is registered at the registration marks on the semiconductor wafer, that subsequently in a site in the vicinity of the first pattern, the second pattern is written on the semiconductor wafer, and that by means of this electron beam system the relative deviation between the second pattern and the first pattern is measured in at least one axial direction as relative error which can be used for calculating the overlay error for further patterns on the semiconductor wafer.

3. Method as claimed in claim 2, characterized in that from the signal generated through electron back-scattering pairs of signal transitions are detected which occur when the electron beam crosses the edges of a predetermined pattern.

**Revendications**

1. Procédé pour mesurer, à l'aide d'un faisceau électronique, une erreur de positionnement entre deux configurations superposées l'une à l'autre à des emplacements sélectionnés dans une tranche semi-conductrice ayant des repères de positionnement, caractérisé en ce que:

une première configuration de positionnement (56, 56A; 57, 57A) est formée sur la tranche semi-conductrice à un emplacement prédéterminé par rapport aux repères de positionnement,

qu'ensuite une seconde configuration de positionnement (58, 59) est formée dans une couche se trouvant sur cette première configuration de positionnement à un emplacement prédéterminé par rapport aux repères de positionnement,

qu'ensuite la distance latérale relative entre les seconde et première configurations de positionnement est mesurée, à l'aide du balayage par faisceau électronique, dans au moins une direction de balayage, qu'est déterminée, entre les deux configurations de positionnement, l'erreur de positionnement qui est proportionnelle à la distance mesurée, en déterminant, pendant le balayage par le faisceau électronique, dans le signal produit par la réflexion des électrons, les transitions de signal qui apparaissent lors de la traversée des bords des configurations de positionnement, et que sont déterminées à partir du traitement de ces transitions de signal les lignes médianes des deux configurations de positionnement et leur espacement mutuel, ce qui permet de calculer l'erreur de positionnement entre les deux configurations de positionnement.

2. Procédé selon la revendication 1, caractérisé en ce que:

la première configuration de positionnement est imprimée à l'aide d'un faisceau électronique par rapport aux repères de positionnement se trouvant à l'emplacement prédéterminé sur la tranche semi-conductrice,

qu'ensuite le faisceau électronique est positionné sur les repères de positionnement se trouvant sur la tranche semi-conductrice, qu'ensuite la seconde configuration de positionnement est imprimée à un emplacement sur la tranche semi-conductrice située au voisinage de la première configuration de positionnement, et

que, à l'aide de ce système de faisceau électronique, la déviation relative entre les seconde et première configurations de positionnement est mesurée, dans au moins une direction axiale, comme erreur relative qui peut être utilisée pour le calcul de l'erreur de positionnement pour d'autres configurations ultérieures sur la tranche semi-conductrice.

3. Procédé selon la revendication 2, caractérisé en ce que:

à partir du signal produit par la réflexion électronique, on détecte des paires de transitions de signal qui apparaissent lorsque le faisceau électronique traverse les bords d'une configuration prédéterminée.

**FIG. 1**

FIG. 2

**FIG. 3**

MITTELLINIE

$\Delta E$

MITTELLINIE

**FIG. 4A**

**FIG. 4B**